# EUROPEAN PATENT SPECIFICATION

(11) **EP 2 764 761 B1**
(45) Date of publication and mention of the grant of the patent: **16.03.2016**
(21) Application number: 12783127.9
(22) Date of filing: 26.09.2012
(51) Int. Cl.: H05K 5/02

(54) **FIXING AND MONITORING DEVICE**
BEFESTIGUNGS- UND ÜBERWACHUNGSVORRICHTUNG
DISPOSITIF DE FIXATION ET DE CONTRÔLE

(30) Priority: 04.10.2011 DE 102011083953
(43) Date of publication of application: 13.08.2014
(73) Proprietor: TE Connectivity Germany GmbH, 64625 Bensheim (DE)
(72) Inventor: RIEDL, Gerhard, 76297 Friedrichstal (DE)
(74) Representative: Patentanwaltskanzlei WILHELM & BECK
(86) International application number: PCT/EP2012/068932
(87) International publication number: WO 2013/050278

(56) References cited:
- WO-A1-2006/108392
- DE-B3-102006 047 187
- DE-C1- 19 606 481
- JP-A- 9 263 221
- JP-A- 2009 008 598

## Description

The present invention relates to a fixing and monitoring device according to patent claim 1.

Fixing and monitoring devices for monitoring apparatuses are known from the prior art. For example, fixing and monitoring devices for monitoring clutches of motor vehicles are known. It is known to construct such fixing and monitoring devices in a modular manner. In this instance, one or more modules of the fixing and monitoring device are arranged in a housing of the fixing and monitoring device. It is desirable for the arrangement and fixing of such a module in the housing of the fixing and monitoring device to be configured in the most simple manner possible. In the prior art, in order to fix a module in a housing of a fixing and monitoring device, additional production steps, such as hot stamping steps, are required. JP 9 263221 A discloses a related art.

An object of the present invention is to provide an improved fixing and monitoring device. This object is achieved by a fixing and monitoring device having the features of claim 1. Preferred developments are set out in the dependent claims.

A fixing and monitoring device according to the invention comprises a sensor housing and a sensor carrier. The sensor housing has a receiving region in which a slotted guide is provided. Furthermore, the sensor carrier has a plurality of guiding pins and is arranged in the receiving region. The guiding pins are guided in the slotted guide. Advantageously, in order to assemble this fixing and monitoring device, no separate production steps are required to fix the sensor carrier in the receiving region of the sensor housing. Furthermore, it is possible for the sensor housing in the receiving region not to have any undercut portions which advantageously simplifies the production of the sensor housing.

In a preferred embodiment of the fixing and monitoring device, the slotted guide comprises a first slotted member and a second slotted member. In this instance, the first slotted member is arranged on a first wall of the receiving region, whilst the second slotted member is arranged on a second wall of the receiving region facing the first wall. This advantageously allows two-sided guiding of the sensor carrier which is arranged in the receiving region of the sensor housing, whereby the sensor carrier can be assembled in the receiving region of the sensor housing in a particularly simple manner.

In a particularly preferred embodiment of the fixing and monitoring device, the first slotted member and the second slotted member are constructed in a mutually mirror-symmetrical manner. Advantageously, the assembly of the sensor carrier in the receiving region of the sensor housing is thereby simplified. Furthermore, the configuration of the sensor housing and sensor carrier is advantageously simplified.

In one embodiment of the fixing and monitoring device, the first slotted member has a first slot and a second slot which is parallel with the first slot. In this instance, the receiving region has an upper edge. Furthermore, the first slot and the second slot are inclined at an angle relative to an extension direction which is perpendicular with respect to the upper edge. Advantageously, a force which acts on the sensor carrier in the direction towards the upper edge then brings about only a reduced force which drives the sensor carrier counter to the extension direction of the slots, whereby a particularly stable arrangement of the sensor carrier in the receiving region of the sensor housing is achieved.

Preferably, the angle is between 20° and 40°, in a particularly preferred manner approximately 30°. Advantageously, these angular ranges are a favourable comprise between a capacity for simple assembly of the sensor carrier in the receiving region of the sensor housing and particularly stable fixing of the sensor carrier in the receiving region of the sensor housing.

In a development of the fixing and monitoring device, the sensor carrier has a first outer side and a second outer side facing the first outer side. In this instance, the first outer side has a first guiding pin and a second guiding pin. Furthermore, the first guiding pin is guided in the first slot and the second guiding pin is guided in the second slot. Advantageously, this is a particularly space-saving and material-saving construction of the sensor carrier and allows simple and stable fixing of the sensor carrier in the receiving region of the sensor housing.

In a particularly preferred embodiment of the fixing and monitoring device, the first guiding pin and/or the second guiding pin are constructed in a slotted manner. Advantageously, the first guiding pin and/or the second guiding pin are then resiliently deformable, which enables the sensor carrier to be fixed in the receiving region of the sensor housing by the application of a force with resilient deformation.

In a development of the fixing and monitoring device, the first slotted member has a third slot. Furthermore, the first outer side of the sensor carrier has a third guiding pin which is arranged in the third slot. Advantageously, the third guiding pin which is arranged in the third slot then serves to fix the sensor carrier in the receiving region of the sensor housing.

In a particularly preferred embodiment of the fixing and monitoring device, the first slotted member and the first guiding pin, the second guiding pin and the third guiding pin are constructed in such a manner that the first guiding pin and the second guiding pin must be resiliently deformed in order to move the third guiding pin in the third slot. Advantageously, the sensor carrier can then be fixed in the receiving region of the sensor housing in a simple manner. Furthermore, the sensor carrier is advantageously prevented from becoming inadvertently released from the receiving region of the sensor housing.

In a development of the fixing and monitoring device, the sensor carrier is covered in the receiving region of the sensor housing by a casting compound. Advantageously, the casting compound can then serve to protect the sensor carrier from environmental influences acting on the sensor housing. Another advantage is that a thermal expansion of the casting compound owing to the fixing of the sensor carrier in the receiving region of the sensor housing does not lead to the sensor carrier becoming released from the receiving region of the sensor housing.

In a preferred embodiment of the fixing and monitoring device, the receiving region of the sensor housing is covered by a circuit board. Advantageously, electrical and electronic components for evaluating data detected by the sensor carrier may be provided on the circuit board. Another advantage of the fixing and monitoring device is also that a thermal expansion of the casting compound does not lead to an application of force to the circuit board.

In an additional development of the fixing and monitoring device, the receiving region of the sensor housing is covered by a cover. Advantageously, the cover prevents dirt and moisture from being introduced inside the sensor housing.

In an embodiment of the fixing and monitoring device, it is provided for monitoring a clutch of a motor vehicle. Advantageously, the fixing and monitoring device can then be used, for example, for monitoring a speed of a gear main shaft.

The invention is explained in greater detail below with reference to Figures, in which:
Figure 1 is a first perspective view of a sensor housing of a fixing and monitoring device;
Figure 2 is a second perspective view of the sensor housing;
Figure 3 is a sectioned view of the sensor housing;
Figure 4 is a perspective illustration of a sensor carrier of the fixing and monitoring device;
Figure 5 is a semi-transparent illustration of the sensor carrier which is arranged in a receiving region of the sensor housing;
Figure 6 is a sectioned and partially transparent illustration of the sensor carrier in the receiving region of the sensor housing;
Figure 7 is a perspective view of the sensor carrier arranged in the receiving region of the sensor housing;
Figure 8 shows the sensor housing with other components;
Figure 9 shows the sensor housing with a circuit board; and
Figure 10 shows the sensor housing of the fixing and monitoring device closed with a cover.

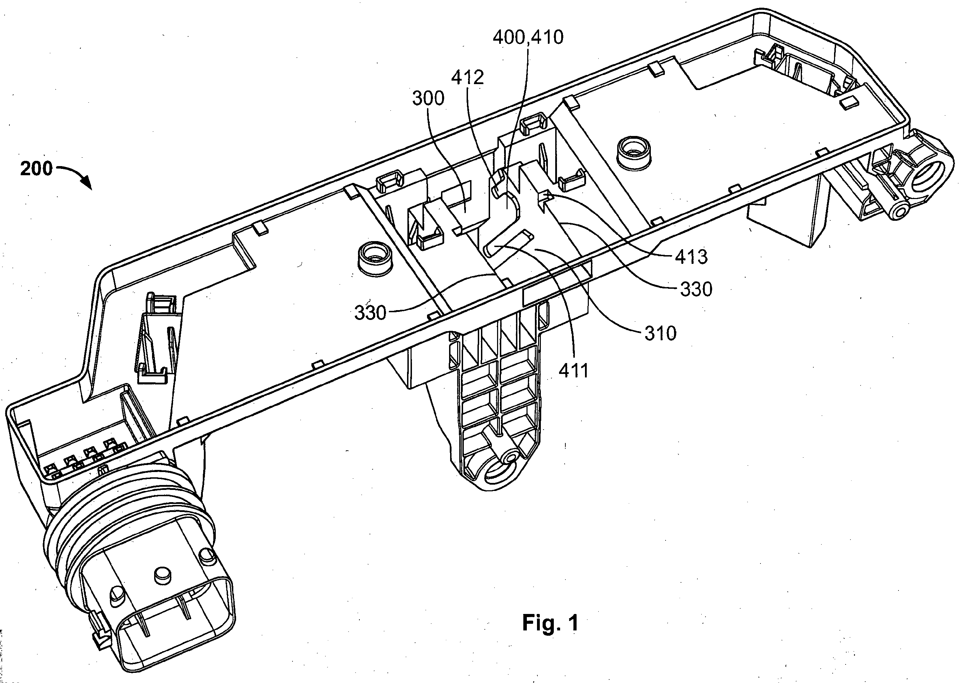

Figure 1 is a perspective view of a sensor housing 200 of a fixing and monitoring device 100. The fixing and monitoring device 100 can be used to monitor a component of an installation, a machine, a motor vehicle or another apparatus. The fixing and monitoring device 100 can be used, for example, to monitor a clutch of a motor vehicle.

The sensor housing 200 of the fixing and monitoring device 100 comprises an electrically insulating material, preferably a plastics material. The sensor housing 200 may have been produced, for example, by means of injection-moulding. The sensor housing 200 is provided to receive one or more sensor components of the fixing and monitoring device 100.

The sensor housing 200 has a receiving region 300 which is constructed as a hollow space in the sensor housing 200 that is open at one side. The receiving region 300 is consequently accessible from a surface of the sensor housing 200. The receiving region 300 has a first wall 310 which delimits the receiving region 300 at one side.

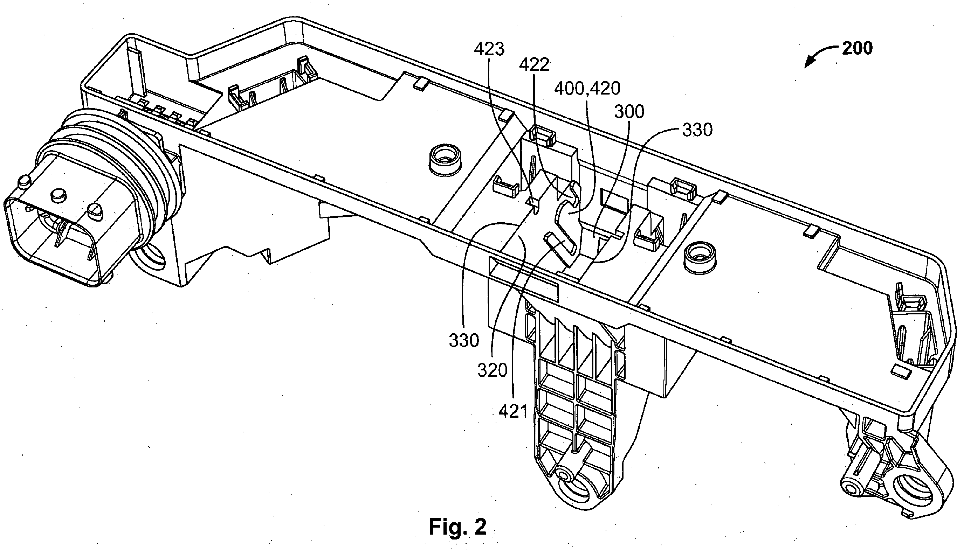

Figure 2 is another perspective view of the sensor housing 200 of the fixing and monitoring device 100 when viewed from another direction. In Figure 2, it can be seen that the receiving region 300 has, facing the first wall 310, a second wall 320 which delimits the receiving region 300 at a second side. In the direction of the opening of the receiving region 300, the receiving region 300 is delimited by an upper edge 330.

In the receiving region 300 of the sensor housing 200, a slotted guide 400 is provided. The slotted guide 400 comprises a first slotted member 410 which is arranged on the first wall 310 of the receiving region 300 and a second slotted member 420 which is arranged on the second wall 320 of the receiving region 300. The first slotted member 410 comprises a first slot 411, a second slot 412 and a third slot 413. The second slotted member 420 is constructed in a mirror-symmetrical manner with respect to the first slotted member 410 and comprises a first slot 421, a second slot 422 and a third slot 423.

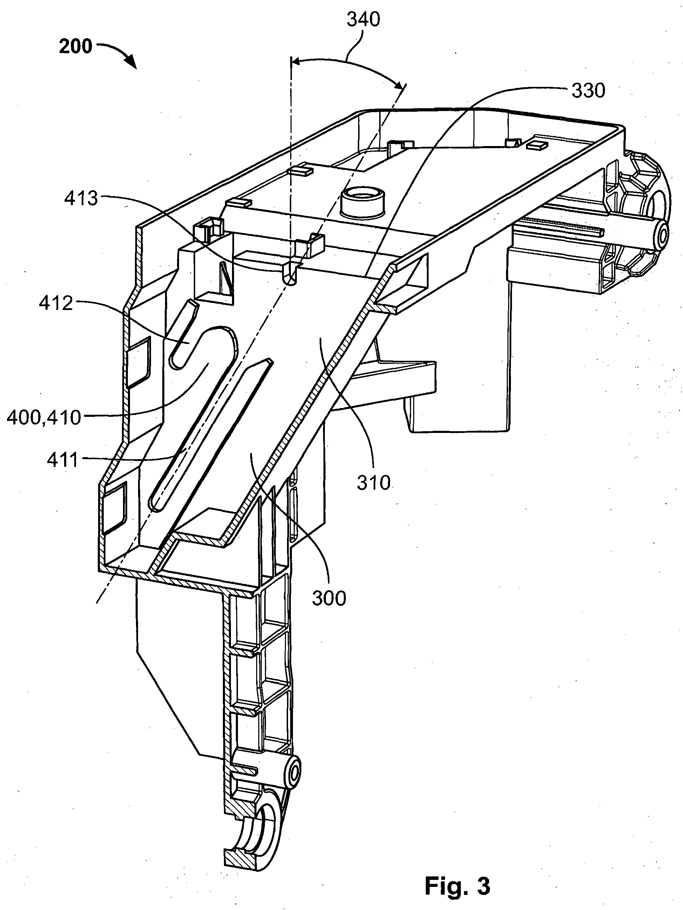

Figure 3 is a sectioned illustration of the sensor housing 200 with the receiving region 300. The section extends parallel with the first wall 310 of the receiving region 300 through the receiving region 300. Consequently, the first wall 310 of the receiving region 300 and the first slotted member 410 of the slotted guide 400 that is arranged on the first wall 310 can be seen in Figure 3.

The first slot 411 of the first slotted member 410 and the second slot 412 of the first slotted member 410 are constructed as elongate slots whose length in the extension direction of the slots 411, 412 is greater than its width perpendicular to the extension direction of the slots 411, 412. The first slot 411 and the second slot 412 are orientated parallel with each other. At a first longitudinal end of the first slot 411 and the second slot 412, the first slot 411 and the second slot 412 are open. Starting from the open longitudinal end thereof, the first slot 411 and the second slot 412 extend more deeply inside the receiving region 300.

The third slot 413 is constructed so as to be shorter than the first slot 411 and the second slot 412. The width of the third slot 413 substantially corresponds to the length of the third slot 413. The third slot 413 is arranged at the upper edge 330 of the first wall 310 of the receiving region 300 in such a manner that the upper edge 330 is interrupted by the third slot 413 and the third slot 413 is open in the direction of the upper edge 330.

The third slot 413 extends from the upper edge 330 perpendicularly relative to the upper edge 330 into the receiving region 300. The first slot 411 and the second slot 412 are inclined at an angle 340 with respect to an orientation which is perpendicular relative to the upper edge 330. Consequently, the longitudinal or extension direction of the first slot 411 has the angle 340 with respect to an orientation which is perpendicular relative to the upper edge 330. Since the second slot 412 is orientated parallel with the first slot 411, the second slot 412 is also inclined through the angle 340 in the extension direction with respect to an orientation which is perpendicular relative to the upper edge 330. The angle 340 is preferably between 20° and 40°. In a particularly preferable manner, the angle 340 is substantially 30°.

The second slotted member 420 on the second wall 320 of the receiving region 300 is constructed in a mirror-symmetrical manner with respect to the first slotted member 410 on the first wall 310 of the receiving region 300. In particular, the first slot 421 and the second slot 422 of the second slotted member 420 are also inclined through the angle 340 with respect to an orientation which is perpendicular relative to the upper edge 330.

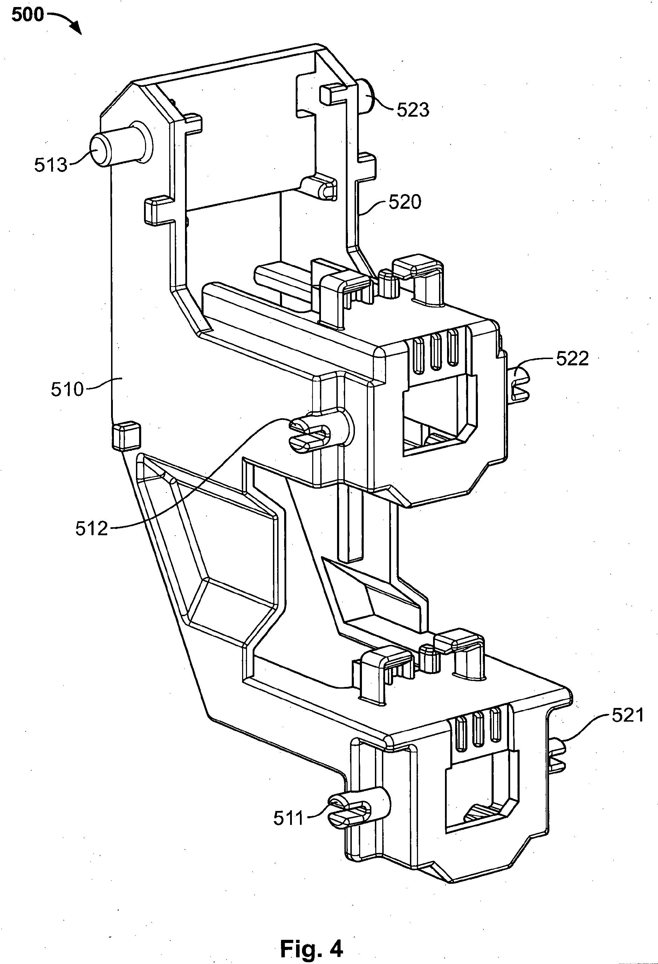

Figure 4 is a perspective view of a sensor carrier 500 of the fixing and monitoring device 100. The sensor carrier 500 comprises an electrically insulating material, preferably a plastics material. The sensor carrier 500 may have been produced, for example, by means of injection-moulding. The sensor carrier 500 is provided to carry sensor elements of the fixing and monitoring device 100. For example, one or more Hall sensors may be arranged on the sensor carrier 500. The sensor elements to be arranged on and in the sensor carrier 500 are not illustrated in Figure 4.

The sensor carrier 500 is provided to be arranged in the receiving region 300 of the sensor housing 200 of the fixing and monitoring device 100. The sensor carrier 500 has a first outer side 510 and a second outer side 520 facing the first outer side 510. A first guiding pin 511, a second guiding pin 512 and a third guiding pin 513 are arranged at the first outer side 510 of the sensor carrier 500. The second outer side 520 of the sensor carrier 500 is constructed in a mirror-symmetrical manner with respect to the first outer side 510 of the sensor carrier 500 and has a first guiding pin 521, a second guiding pin 522 and a third guiding pin 523.

The guiding pins 511, 512, 513 are each constructed as cylindrical pins and arranged perpendicularly on the first outer side 510 of the sensor carrier 500. The guiding pins 521, 522, 523 are constructed correspondingly as cylindrical pins and are arranged perpendicularly on the second outer side 520 of the sensor carrier 500.

The first guiding pin 511 and the second guiding pin 512 on the first outer side 510 of the sensor carrier 500 and the first guiding pin 521 and the second guiding pin 522 on the second outer side 520 of the sensor carrier 500 are each constructed in a slotted manner. Each of these guiding pins 511, 512, 521, 522 has a slot which extends from the covering face of the guiding pin 511, 512, 521, 522 remote from the respective outer side 510, 520 of the sensor carrier 500 parallel with the longitudinal direction of the guiding pin 511, 512, 521, 522 into the guiding pin 511, 512, 521, 522. The depth of the slots may, for example, be substantially half the length of the guiding pins 511, 512, 521, 522. The slotted configuration of the guiding pins 511, 512, 521, 522 allows resilient deformation of the guiding pins 511, 512, 521, 522. The third guiding pins 513, 523 are in contrast rigid and not resiliently deformable.

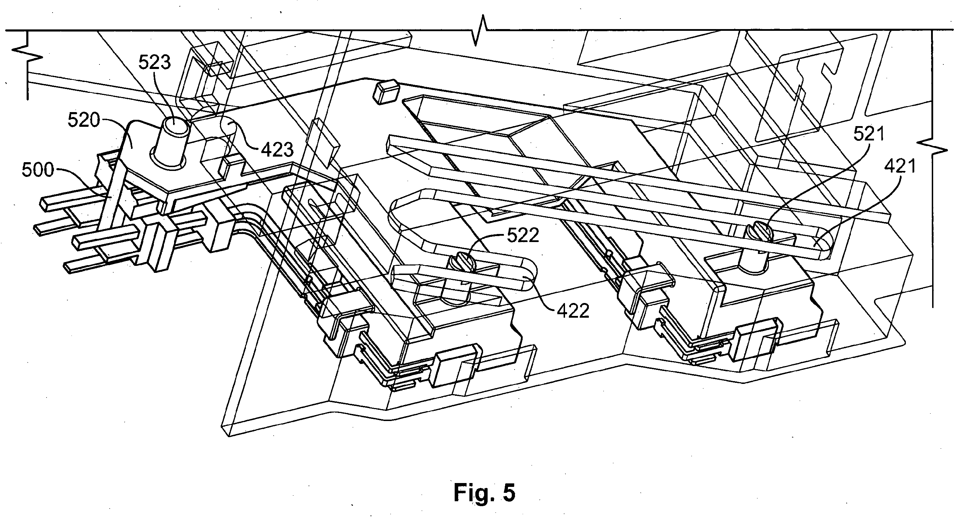

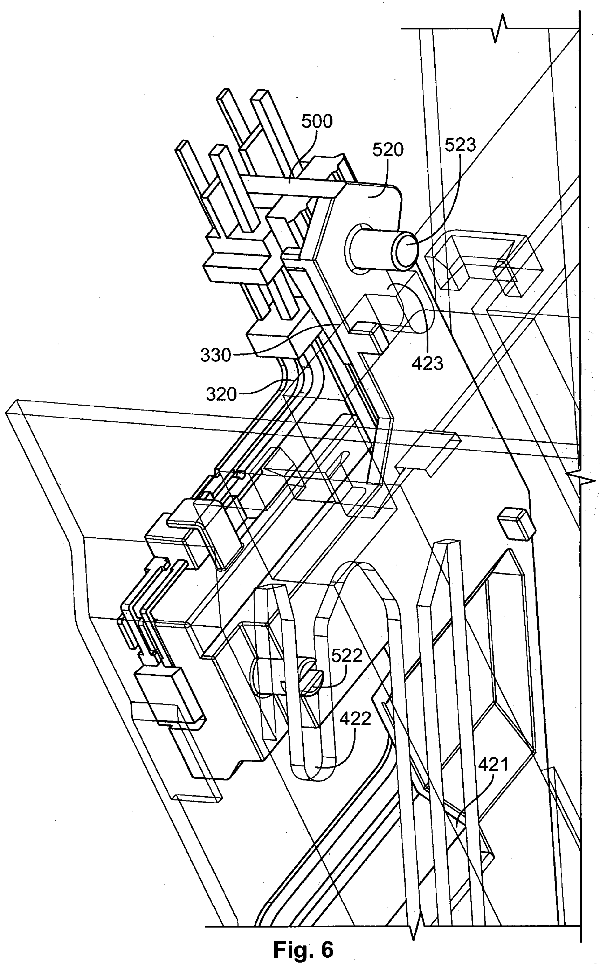

Figures 5 and 6 are two sectioned and semi-transparent illustrations of the sensor housing 200 with the sensor carrier 500 which is arranged in the receiving region 300 of the sensor housing 200. In both illustrations, the sensor carrier 500 is not yet completely introduced into the receiving region 300 of the sensor housing 200. In both illustrations, the second wall 320 of the receiving region 300 and the second slotted member 420 of the slotted guide 400 arranged on the second wall 320 can be seen.

The first guiding pin 521 on the second outer side 520 of the sensor carrier 500 is arranged in the first slot 421 of the second slotted member 420 of the slotted guide 400. The second guiding pin 522 on the second outer side 520 of the sensor carrier 500 is guided in the second slot 422 of the second slotted member 420. Accordingly, but not illustrated in Figures 5 and 6, the first guiding pin 511 at the first outer side 510 of the sensor carrier 500 is also guided in the first slot 411 of the first slotted member 410 on the first wall 310 of the receiving region 300. The second guiding pin 512 on the first outer side 510 of the sensor carrier 500 is guided in the second slot 412 of the first slotted member 410 of the slotted guide 400.

The sensor carrier 500 can be introduced in the slotted guide 400 into the receiving region 300 of the sensor housing 200 until the third guiding pin 513 at the first outer side 510 of the sensor carrier 500 and the third guiding pin 523 at the second outer side 520 of the sensor carrier 500 come into abutment with the upper edge 330 of the receiving region 300. This situation is illustrated in Figures 5 and 6. At this point, the sensor carrier 500 must be pushed with a degree of application of force by means of excess pressure further into the receiving region 300 to such an extent that ultimately the third guiding pin 513 on the first outer side 510 of the sensor carrier 500 comes to rest in the third slot 413 of the first slotted member 410 on the first wall 310 of the receiving region 300 and the third guiding pin 523 on the second outer side 520 of the sensor carrier 500 comes to rest in the third slot 423 of the second slotted member 420 on the second wall 320 of the receiving region 300. During the forcing process of the excess pressure, there is a temporary resilient deformation of the slotted first and second guiding pins 511, 512, 521, 522 which allows the sensor carrier 500 to be moved further into the receiving region 300 without the sensor carrier 500, the receiving region 300 or other components of the fixing and monitoring device 100 becoming damaged.

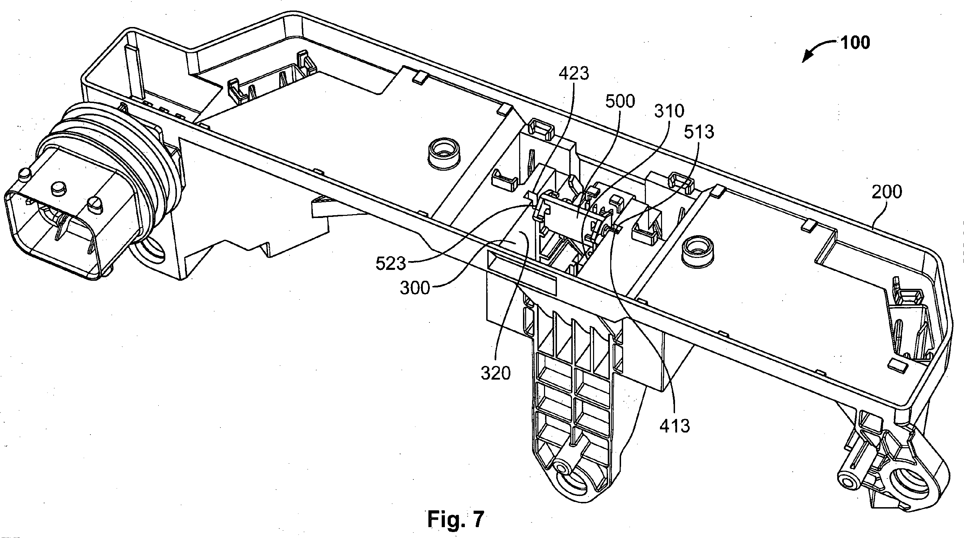

Figure 7 is a perspective illustration of the sensor housing 200 of the fixing and monitoring device 100 with the sensor carrier 500 which is completely arranged in the receiving region 300 of the sensor housing 200. The third guiding pin 513 at the first outer side 510 of the sensor carrier 500 is arranged in the third slot 413 of the first slotted member 410 on the first wall 310 of the receiving region 300. The third guiding pin 523 on the second outer side 520 of the sensor carrier 500 is arranged in the third slot 423 of the second slotted member 420 on the second wall 320 of the receiving region 300. Since excess pressure using application of force was required to bring the sensor carrier 500 into the receiving region 300, the sensor carrier 500 in the end position illustrated in Figure 7 is secured against inadvertent removal from the receiving region 300.

The sensor carrier 500 which is arranged in the receiving region 300 of the sensor housing 200 can be cast in a subsequent operating step into a casting compound. The casting compound may in this instance, for example, fill the entire receiving region 300 and completely surround the sensor carrier 500. Advantageously, the sensor carrier 500 and sensor components arranged on the sensor carrier 500 are then protected by the casting compound from damage owing to environmental influences, for example, damage by dust and moisture.

If the fixing and monitoring device 100 becomes warm during operation, the casting compound may thermally expand to a greater extent than the sensor carrier 500 and the sensor housing 200 owing to different thermal expansion coefficients. In the case of temperature expansion of the casting compound, the sensor carrier 500 can move only in the slotted guide 400. Owing to the arrangement of the first and second slots 411, 412, 421, 422 at the angle 340, a force which is brought about by the temperature expansion of the casting compound brings about a first component which presses the third guiding pins 513, 523 of the sensor carrier 500 against the slotted walls of the third slots 413, 423 of the slotted guide 400, and another component, which attempts to move the sensor carrier 500 out of the receiving region 300 which is prevented by the first and second guiding pins 511, 512, 521, 522 of the sensor carrier 500 arranged in the first slots 411, 412, 421, 422 of the slotted guide 400.

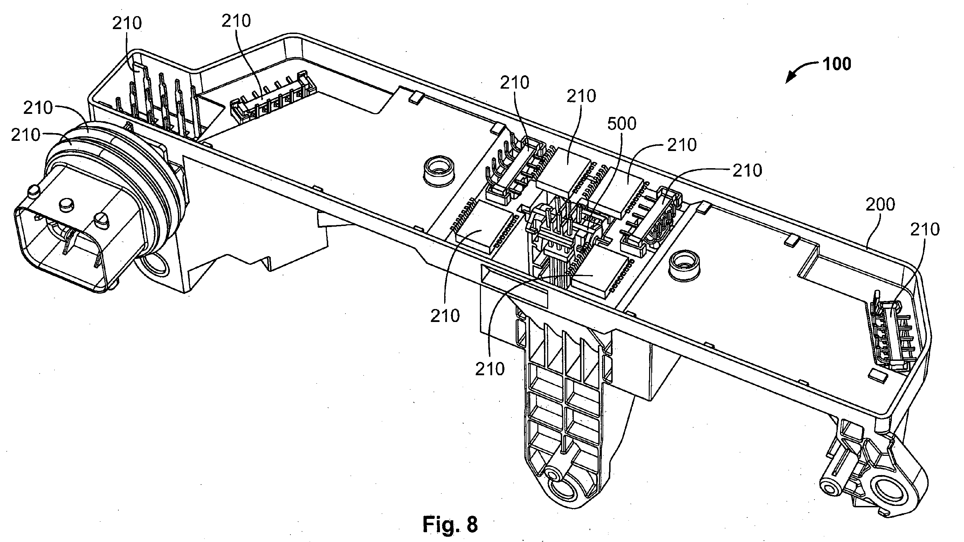

Figure 8 is another view of the fixing and monitoring device 100 with the sensor housing 200 and the sensor carrier 500 arranged in the receiving region 300 of the sensor housing 200. The sensor housing 200 has been provided with a plurality of additional components 210. These additional components 210 may be other sensor elements or other components. The casting of the sensor carrier 500 arranged in the receiving region 300 with casting compound can also take place only after the sensor housing 200 has been provided with the other components 210. The additional components 210 may also be dispensed with.

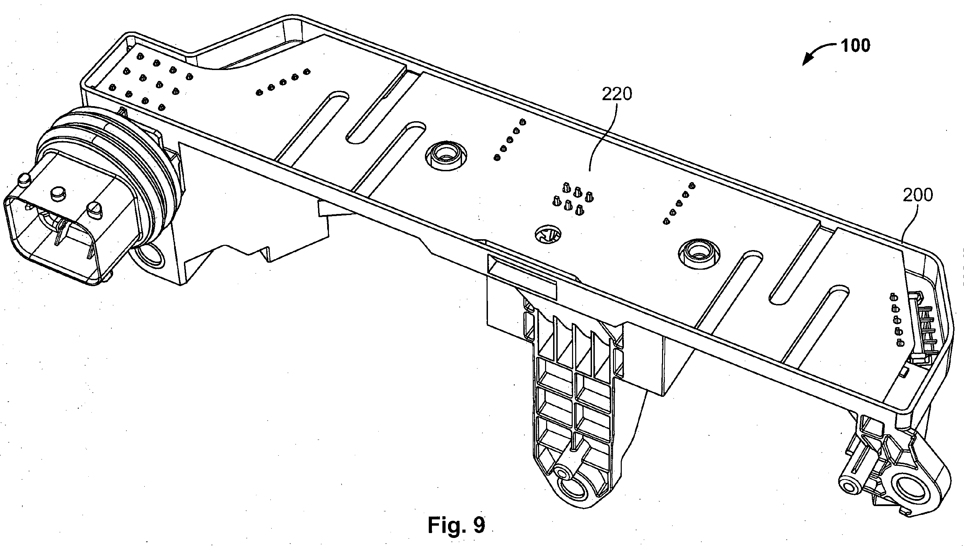

Figure 9 is another perspective illustration of the fixing and monitoring device 100 with the sensor housing 200. In the illustration of Figure 9, a circuit board 220 has been secured to the sensor housing 200. The circuit board 220 covers the receiving region 300 and the sensor carrier 500 arranged in the receiving region 300. The circuit board 220 may have switch arrangements and electrical or electronic components of the fixing and monitoring device 100. On the circuit board 220, there may also be provided switch arrangements which serve to control the sensor components arranged on the sensor carrier 500.

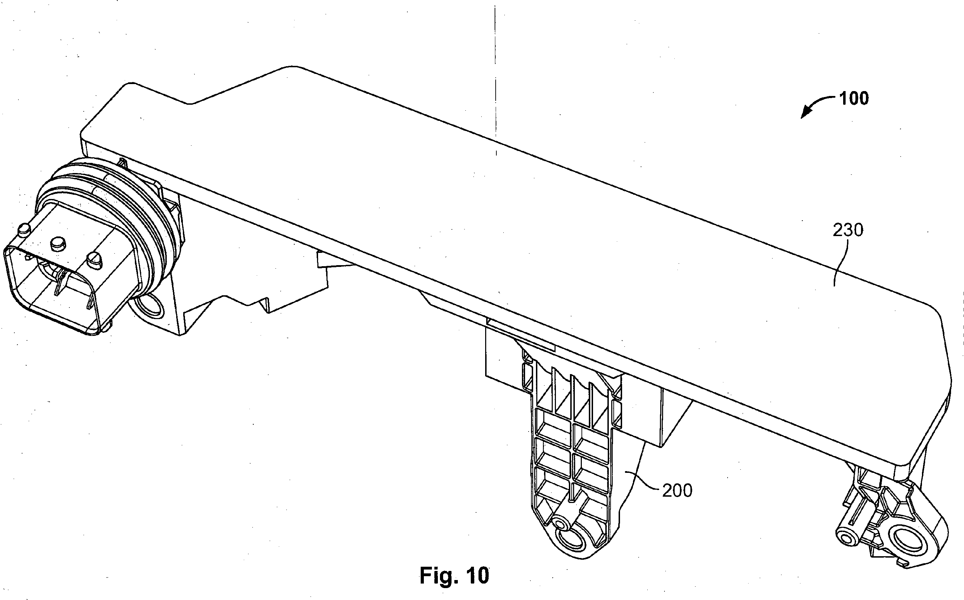

Figure 10 is a perspective illustration of the fully mounted fixing and monitoring device 100. The circuit board 220 has been covered by a cover 230. The sensor housing 200 of the fixing and monitoring device 100 is closed by the cover 230. The cover 230 may be constructed in such a sealing manner that it prevents dirt and moisture from being introduced inside the sensor housing 200.

In summary, the invention provides a modular fixing and monitoring device with a sensor housing and a sensor carrier which can be arranged in a receiving region of the sensor housing. The arrangement and fixing of the sensor carrier in the receiving region of the sensor housing advantageously requires no additional production steps in this instance and also does not require that the sensor housing be constructed with undercut portions.

## Claims

1. Fixing and monitoring device (100) particularly for monitoring a clutch of a motor vehicle, having a sensor housing (200)
and a sensor carrier (500),
the sensor housing (200) having a receiving region (300) in which a slotted guide (400) is provided,
the slotted guide (400) comprising a first slotted member (410) and a second slotted member (420),
the first slotted member (410) being arranged on a first wall (310) of the receiving region (300),
the second slotted member (420) being arranged on a second wall (320) of the receiving region (300) facing the first wall (310),
the first slotted member (410) having a first slot (411) and a second slot (412) which is parallel with the first slot (411),
the receiving region (300) having an upper edge (330),
the first slot (411) and the second slot (412) being inclined at an angle (340) relative to an extension direction which is perpendicular with respect to the upper edge (330),
the sensor carrier (500) having a plurality of guiding pins (511, 512, 513, 521, 522, 523),
the sensor carrier (500) being arranged in the receiving region (300),
the guiding pins (511, 512, 513, 521, 522, 523) being guided in the slotted guide (400).

2. Fixing and monitoring device (100) according to claim 1,
the first slotted member (410) and the second slotted member (420) being constructed in a mutually mirror-symmetrical manner.

3. Fixing and monitoring device (100) according to either claim 1 or claim 2,
the angle (340) being between 20° and 40°, preferably approximately 30°.

4. Fixing and monitoring device (100) according to any one of the preceding claims,
the sensor carrier (500) having a first outer side (510) and a second outer side (520) facing the first outer side (510), the first outer side (510) having a first guiding pin (511) and a second guiding pin (512),
the first guiding pin (511) being guided in the first slot (411) and the second guiding pin (512) being guided in the second slot (412).

5. Fixing and monitoring device (100) according to claim 4,
the first guiding pin (511) and/or the second guiding pin (512) being slotted.

6. Fixing and monitoring device (100) according to either claim 4 or claim 5,
the first slotted member (410) having a third slot (413), the first outer side (510) of the sensor carrier (500) having a third guiding pin (513),
the third guiding pin (513) being arranged in the third slot (413).

7. Fixing and monitoring device (100) according to claim 6,
the first slotted member (410) and the first guiding pin (511), the second guiding pin (512) and the third guiding pin (513) being constructed in such a manner that the first guiding pin (511) and the second guiding pin (512) must be resiliently deformed in order to move the third guiding pin (511) in the third slot (411).

8. Fixing and monitoring device (100) according to any one of the preceding claims, the sensor carrier (500) being covered in the receiving region (300) of the sensor housing (200) by a casting compound.

9. Fixing and monitoring device (100) according to any one of the preceding claims, the receiving region (300) of the sensor housing (200) being covered by a circuit board (220).

10. Fixing and monitoring device (100) according to any one of the preceding claims, the receiving region (300) of the sensor housing (200) being covered by a cover (230).

11. Fixing and monitoring device (100) according to any one of the preceding claims, the fixing and monitoring device (100) being provided to monitor a clutch of a motor vehicle.

## Patentansprüche

1. Befestigungs- und Überwachungsvorrichtung (100), insbesondere zum Überwachen einer Kupplung eines Kraftfahrzeugs,
mit einem Sensorgehäuse (200)
und einem Sensorträger (500),
wobei das Sensorgehäuse (200) einen Aufnahmebereich (300) aufweist, in welchem eine geschlitzte Führung (400) vorgesehen ist,
wobei die geschlitzte Führung (400) ein erstes geschlitztes Element (410) und ein zweites geschlitztes Element (420) aufweist,
wobei das erste geschlitzte Element (410) an einer ersten Wand (310) des Aufnahmebereichs (300) angeordnet ist,
wobei das zweite geschlitzte Element (420) an einer der ersten. Wand (310) zugewandten zweiten Wand (320) des Aufnahmebereichs (300) angeordnet ist,
wobei das erste geschlitzte Element (410) einen ersten Schlitz (411) und einen zweiten Schlitz (412), welcher parallel zum ersten Schlitz (411) verläuft, aufweist,
wobei der Aufnahmebereich (300) eine obere Kante (330) aufweist,
wobei der erste Schlitz (411) und der zweite Schlitz (412) um einem Winkel (340) bezüglich einer Erstreckungsrichtung, welche in Bezug auf die obere Kante (330) senkrecht ist, geneigt sind,
wobei der Sensorträger (500) eine Vielzahl von Führungszapfen (511, 512, 513, 521, 522, 523) aufweist, wobei der Sensorträger (500) im Aufnahmebereich (300) angeordnet ist,
wobei die Führungszapfen (511, 512, 513, 521, 522, 523) in der geschlitzten Führung (400) geführt werden.

2. Befestigungs- und Überwachungsvorrichtung (100) nach Anspruch 1,
wobei das erste geschlitzte Element (410) und das zweite geschlitzte Element (420) in einer gegenseitig spiegelsymmetrischen Weise ausgestaltet sind.

3. Befestigungs- und Überwachungsvorrichtung (100) nach entweder Anspruch 1 oder Anspruch 2,
wobei der Winkel (340) zwischen 20° und 40°, vorzugsweise ungefähr 30°, beträgt.

4. Befestigungs- und Überwachungsvorrichtung (100) nach einem der vorhergehenden Ansprüche,
wobei der Sensorträger (500) eine erste Außenseite (510) und eine der ersten Außenseite (510) zugewandte zweite Außenseite (520) aufweist, wobei die erste Außenseite (510) einen ersten Führungszapfen (511) und einen zweiten Führungszapfen (512) aufweist,
wobei der erste Führungszapfen (511) im ersten Schlitz (411) geführt wird und der zweite Führungszapfen (512) im zweiten Schlitz (412) geführt wird.

5. Befestigungs- und Überwachungsvorrichtung (100) nach Anspruch 4,
wobei der erste Führungszapfen (511) und/oder der zweite Führungszapfen (512) geschlitzt sind/ist.

6. Befestigungs- und Überwachungsvorrichtung (100) nach entweder Anspruch 4 oder Anspruch 5,
wobei das erste geschlitzte Element (410) einen dritten Schlitz (413) aufweist,
wobei die erste Außenseite (510) des Sensorträgers (500) einen dritten Führungszapfen (513) aufweist, wobei der dritte Führungszapfen (513) im dritten Schlitz (413) angeordnet ist.

7. Befestigungs- und Überwachungsvorrichtung (100) nach Anspruch 6,
wobei das erste geschlitzte Element (410) und der erste Führungszapfen (511), der zweite Führungszapfen (512) und der dritte Führungszapfen (513) in einer derartigen Weise ausgestaltet sind, dass der erste Führungszapfen (511) und der zweite Führungszapfen (512) federnd verformt werden müssen, um den dritten Führungszapfen (511) im dritten Schlitz (411) zu bewegen.

8. Befestigungs- und Überwachungsvorrichtung (100) nach einem der vorhergehenden Ansprüche,
wobei der Sensorträger (500) im Aufnahmebereich (300) des Sensorgehäuses (200) von einer Vergussmasse abgedeckt wird.

9. Befestigungs- und Überwachungsvorrichtung (100) nach einem der vorhergehenden Ansprüche,
wobei der Aufnahmebereich (300) des Sensorgehäuses (200) von einer Leiterplatte (220) abgedeckt wird.

10. Befestigungs- und Überwachungsvorrichtung (100) nach einem der vorhergehenden Ansprüche,
wobei der Aufnahmebereich (300) des Sensorgehäuses (200) von einer Abdeckung (230) abgedeckt wird.

11. Befestigungs- und Überwachungsvorrichtung (100) nach einem der vorhergehenden Ansprüche,
wobei die Befestigungs- und Überwachungsvorrichtung (100) dafür vorgesehen ist, eine Kupplung eines Kraftfahrzeugs zu überwachen.

## Revendications

1. Dispositif de fixation et de contrôle (100) en particulier pour contrôler un embrayage d'un véhicule automobile, comprenant un boîtier de capteur (200) et un support de capteur (500), le boîtier de capteur (200) ayant une région de réception (300) dans laquelle est prévu un guide à fente (400), le guide à fente (400) comprenant un premier organe à fente (410) et un deuxième organe à fente (420), le premier organe à fente (410) étant disposé sur une première paroi (310) de la région de réception (300), le deuxième organe à fente (420) étant disposé sur une deuxième paroi (320) de la région de réception (300) faisant face à la première paroi (310), le premier organe à fente (410) ayant une première fente (411) et une deuxième fente (412) qui est parallèle à la première fente (411), la région de réception (300) ayant un bord supérieur (330), la première fente (411) et la deuxième fente (412) étant inclinées suivant un angle (340) par rapport à une direction d'étendue qui est perpendiculaire au bord supérieur (330), le support de capteur (500) ayant une pluralité de broches de guidage (511, 512, 513, 521, 522, 523), le support de capteur (500) étant disposé dans la région de réception (300), les broches de guidage (511, 512, 513, 521, 522, 523) étant guidées dans le guide à fente (400).

2. Dispositif de fixation et de contrôle (100) selon la revendication 1, le premier organe à fente (410) et le deuxième organe à fente (420) étant construits avec une symétrie spéculaire l'un par rapport à l'autre.

3. Dispositif de fixation et de contrôle (100) selon la revendication 1 ou 2, l'angle (340) étant compris entre 20° et 40°, de préférence valant approximativement 30°.

4. Dispositif de fixation et de contrôle (100) selon l'une quelconque des revendications précédentes, le support de capteur (500) ayant un premier côté extérieur (510) et un deuxième côté extérieur (520) en regard du premier côté extérieur (510), le premier côté extérieur (510) ayant une première broche de guidage (511) et une deuxième broche de guidage (512), la première broche de guidage (511) étant guidée dans la première fente (411) et la deuxième broche de guidage (512) étant guidée dans la deuxième fente (412).

5. Dispositif de fixation et de contrôle (100) selon la revendication 4, la première broche de guidage (511) et/ou la deuxième broche de guidage (512) étant fendues.

6. Dispositif de fixation et de contrôle (100) selon la revendication 4 ou 5, le premier organe à fente (410) ayant une troisième fente (413), le premier côté extérieur (510) du support de capteur (500) ayant une troisième broche de guidage (513), la troisième broche de guidage (513) étant disposée dans la troisième fente (413).

7. Dispositif de fixation et de contrôle (100) selon la revendication 6, le premier organe à fente (410) et la première broche de guidage (511), la deuxième broche de guidage (512) et la troisième broche de guidage (513) étant construites de telle sorte que la première broche de guidage (511) et la deuxième broche de guidage (512) doivent être déformées élastiquement afin de déplacer la troisième broche de guidage (511) dans la troisième fente (411).

8. Dispositif de fixation et de contrôle (100) selon l'une quelconque des revendications précédentes, le support de capteur (500) étant recouvert dans la région de réception (300) du boîtier de capteur (200) par une masse de coulée.

9. Dispositif de fixation et de contrôle (100) selon l'une quelconque des revendications précédentes, la région de réception (300) du boîtier de capteur (200) étant recouverte par une carte à circuits imprimés (220).

10. Dispositif de fixation et de contrôle (100) selon l'une quelconque des revendications précédentes, la région de réception (300) du boîtier de capteur (200) étant recouverte par un couvercle (230).

11. Dispositif de fixation et de contrôle (100) selon l'une quelconque des revendications précédentes, le dispositif de fixation et de contrôle (100) étant prévu pour contrôler un embrayage d'un véhicule à moteur.
